# EUROPÄISCHE PATENTANMELDUNG

(11) **EP 3 967 859 A1**
(43) Veröffentlichungstag der Anmeldung: **16.03.2022**
(21) Anmeldenummer: 20196002.8
(22) Anmeldetag: 14.09.2020
(51) Int. Cl.: F02B 37/10, F02B 39/00, F02B 39/10, F04D 25/06, H02K 5/22, H02K 11/33, H05K 7/20, F01P 3/12, F04B 39/12, H02K 5/20

(54) **ELEKTRONIKEINHEIT ZUR REGELUNG UND ZUM BETREIBEN EINES ELEKTROMOTORS**

(71) Anmelder: BMTS Technology GmbH & Co. KG, 70376 Stuttgart (DE)
(72) Erfinder: VOGLER, Rainer, 71397 Leutenbach (DE); WENDLAND, Michael, 70376 Stuttgart (DE); BEYERLEIN, Sebastian, 73765 Neuhausen auf den Fildern (DE); KLEINSCHMIDT, Rüdiger, 74354 Besigheim (DE)
(74) Vertreter: Herrmann, Jochen

(57) **Zusammenfassung**

Die Erfindung betrifft eine Elektronikeinheit zur Regelung eines Elektromotors, insbesondere zur Regelung eines Elektromotors zum Antrieb eines Verdichters, insbesondere Gasverdichters, mit einem Elektronikgehäuse (20), in dessen Aufnahmeraum eine Leistungselektronik zur Regelung des Elektromotors aufgenommen ist, wobei das Elektronikgehäuse (20) eine Anschlusswand (21) aufweist, mit der das Elektronikgehäuse (20) an eine Außenfläche (15.1) eines Aufnahmegehäuses, in dem ein Elektromotor untergebracht ist, ankoppelbar ist. Bei einer solchen Elektronikeinheit wird ein platzoptimiertes Elektronikgehäuse für eine Leistungselektronik zur Regelung eines Elektromotors eines Verdichters dann bereitstellt, wenn vorgesehen ist, dass das Elektronikgehäuse (20) gegenüberliegend der Anschlusswand (21) eine Gehäuseöffnung aufweist, die mit einer Abdeckung (30) verschließbar ist und durch die hindurch der Aufnahmeraum zugänglich ist, dass eine Leiterplatte (46) zur Aufnahme zumindest eines Teils der Leistungselektronik im Bereich hinter der Gehäuseöffnung im Aufnahmeraum angeordnet ist und die eine Längs- und eine Quererstreckung aufweist, wobei die Längserstreckung in Richtung der Gehäuselänge und die Quererstreckung in Richtung der Gehäusebreite verläuft, und dass die Anschlusswand (21) in Richtung der Quererstreckung der Leiterplatte (46) geneigt zu der Leiterplatte (46) verläuft, derart, dass die senkrecht zur Leiterplatte (46) verlaufende Bauraumhöhe des Aufnahmeraums in Richtung der Quererstreckung von einer Gehäuseseite zu der gegenüberliegenden Gehäuseseite zumindest bereichsweise abnimmt.

## Beschreibung

Die Erfindung betrifft eine Elektronikeinheit zur Regelung und zum Betreiben eines Elektromotors, insbesondere zur Regelung eines Elektromotors zum Antrieb eines Verdichters, insbesondere eines Gasverdichters, mit einem Elektronikgehäuse, in dessen Aufnahmeraum eine Leistungselektronik zur Regelung des Elektromotors aufgenommen ist, wobei das Elektronikgehäuse eine Anschlusswand aufweist, mit der das Elektronikgehäuse an eine Außenfläche eines Aufnahmegehäuses, in dem der Elektromotor angeordnet ist, ankoppelbar ist.

Gasverdichter im Sinne der Erfindung können insbesondere Abgasturbolader sein, die ein Turbinenrad und ein Verdichterrad aufweisen. Der Elektromotor ist dabei in einem Aufnahmegehäuse des Abgasturboladers untergebracht, welches eine Außenfläche bildet. Der Elektromotor dient dazu die Drehbewegung des Verdichterrads zu unterstützen.

Ein erfindungsgemäßer Verdichter kann auch allgemein in Form eines Turboladers oder Kompressors derart gestaltet sein, dass er ein Verdichterrad aufweist, das von dem Elektromotor angetrieben wird, um einem Verbrennungsmotor oder einer Brennstoffzelle einen komprimierten Gasstrom zuzuführen.

US 7,352,077 B2 offenbart einen elektrisch unterstützten Abgasturbolader. Dieser weist eine Antriebswelle auf, die ein Verdichterrad trägt. Weiterhin ist auf der Antriebswelle eine Turbine befestigt. Die Turbine kann in einem Turbinengehäuse des Aufnahmegehäuses des Turboladers betrieben werden. Der Turbine wird ein Abgasstrom zugeführt, wodurch die Antriebswelle und mit ihr das Verdichterrad in Drehbewegung versetzt wird. Zur Unterstützung dieser Drehbewegung ist im Aufnahmegehäuse ein Elektromotor verbaut. Das Aufnahmegehäuse weist ein Verdichtergehäuse auf, welches einen Spiralkanal bildet. In dem Spiralkanal kann die vom Verdichterrad geförderte Druckluft transportiert und einem Verbrennungsmotor zugeleitet werden. Das Verdichtergehäuse besitzt einen zylindrischen Ansatz. Auf diesen ist ein ringförmiges Elektronikgehäuse aufgeschoben. Das Elektronikgehäuse ist mit Elektronikkomponenten bestückt, die an den Elektromotor angeschlossen sind, um diesen mit Wechselstrom zu versorgen. Weiterhin ist den Elektronikkomponenten eine Gleichspannung zugeleitet. Diese Gleichspannung kann mit den Elektronikkomponenten in eine Wechselspannung für den Elektromotor gewandelt werden.

Aus WO 2020/018479 A1 ist ein Turbolader bekannt, der auf einer Antriebswelle ein Verdichterrad trägt. Die Antriebswelle und das Verdichterrad sind in einem mehrteiligen Verdichtergehäuse untergebracht. In einem separaten Elektronikgehäuse sind elektrische Baueinheiten untergebracht. Zur Kühlung dieser Baueinheiten ist ein Kühlkreislauf verwendet, der durch das Elektronikgehäuse geführt wird.

Bei der Verwendung von elektrischen Motoren zum Antrieb oder der Unterstützung eines Gasverdichters, insbesondere eines Abgasturboladers oder eines Turboladers, spielt die platzsparende Anordnung der mitunter vergleichsweise großen Komponenten der Leistungselektronik zur Steuerung und Regelung des Elektromotors eine bedeutende Rolle. Zudem ist ein hinreichendes Wärmemanagement, das wegen der im Motorraum vorherrschenden Temperaturen und der Temperatursensitivität elektronischer Komponenten unerlässlich ist, bedeutsam.

Es ist Aufgabe der Erfindung, eine Elektronikeinheit der eingangs erwähnten Art zu schaffen, welche ein platzoptimiertes Elektronikgehäuse für eine Leistungselektronik zur Regelung eines Elektromotors eines Verdichters bereitstellt.

Diese Aufgabe wird dadurch gelöst, dass das Elektronikgehäuse gegenüberliegend seiner Anschlusswand eine Gehäuseöffnung aufweist, die mit einer Abdeckung verschließbar ist und durch die hindurch der Aufnahmeraum zugänglich ist, dass eine Leiterplatte zur Aufnahme zumindest eines Teils der Leistungselektronik im Bereich hinter der Gehäuseöffnung im Aufnahmeraum angeordnet ist und die eine Längs- und eine Quererstreckung aufweist, wobei die Längserstreckung in Richtung der Gehäuselänge und die Quererstreckung in Richtung der Gehäusebreite verläuft, und dass die Anschlusswand in Richtung der Quererstreckung der Leiterplatte geneigt zu der Leiterplatte verläuft, derart, dass die senkrecht zur Leiterplatte verlaufende Bauraumhöhe des Aufnahmeraums in Richtung der Quererstreckung von einer Gehäuseseite zu der gegenüberliegenden Gehäuseseite zumindest bereichsweise abnimmt.

Bei einer solchen Elektronikeinheit können die einzelnen Komponenten der Leistungselektronik zur Ansteuerung des Elektromotors platzsparend untergebracht werden. Bauteile mit großer Bauhöhe können in dem Bereich der Gehäuseseite angeordnet werden, die die größte Bauraumhöhe zur Verfügung stellt. Bauteile mit kleiner Bauhöhe können dann eher im Bereich des Aufnahmeraums mit der geringsten Bauraumhöhe positioniert werden. Im Zwischenbereich zwischen diesen beiden Aufnahmeraum-Bereichen lassen sich die übrigen Elektronikkomponenten in Bereichen anordnen, die zu ihrer Bauraumhöhe passen. Auf diese Weise lässt sich, auch im Zusammenspiel mit dem Aufnahmegehäuse, in dem der Elektromotor untergebracht ist, eine kompakte Bauweise verwirklichen. Abhängig von der thermischen Belastung, die extern auf das Aufnahmegehäuse einwirkt, kann das Elektronikgehäuse am Aufnahmegehäuse so positioniert werden, dass das Aufnahmegehäuse eine Art Hitzeschild gegenüber wärmeabgebenden Komponenten, beispielsweise abgasführenden Bauteilen, bildet. Dies kann bei der vorliegenden Erfindung besonders wirksam gelöst werden. Beispielsweise kann zu diesem Zweck, aufgrund der kompakten Bauweise des Elektronikgehäuses, eine geringe Umschlingung des Aufnahmegehäuses durch das Elektronikgehäuse erreicht werden. Besonders vorteilhaft beträgt der Umschlingungswinkel, mit der die Anschlusswand das Aufnahmegehäuse überdeckt, weniger als 180° des Außenumfangs des Aufnahmegehäuses.

Gemäß einer bevorzugten Erfindungsausgestaltung kann es vorgesehen sein, dass ein in Richtung der Quererstreckung der Leiterplatte und in Richtung der Bauraumhöhe verlaufender Querschnitt des Elektronikgehäuses näherungsweise einen dreieckförmigen oder trapezförmigen Querschnitt aufweist. Vorzugsweise weist dabei, bei einer dreieckförmigen Querschnittsform, die Hypotenuse des Dreiecks eine der Außenfläche des Aufnahmegehäuses angepasste, vorzugsweise gerundete, besonders bevorzugt konkave Form auf. Bei einer trapezförmigen Querschnittsform ist vorzugsweise die Form der längsten Seite des trapezförmigen Querschnitts auf die Form der zugekehrten Außenfläche des Aufnahmegehäuses angepasst, vorzugsweise gerundet, besonders bevorzugt konkav gestaltet.

Im Sinne der Erfindung liegt eine dreieckförmige Querschnittsform insbesondere immer dann vor, wenn drei Gehäusewände den Aufnahmeraum zumindest bereichsweise umgeben. Eine fünfeckige, insbesondere eine trapezförmige Querschnittsform, ist insbesondere immer dann gegeben, wenn zumindest fünf Gehäusewände den Aufnahmeraum zumindest bereichsweise umgeben.

Gemäß einer besonders bevorzugten Ausgestaltungsvariante der Erfindung kann es vorgesehen sein, dass die Anschlusswand zumindest bereichsweise eine konkave Form aufweist. Eine solche Form eignet sich insbesondere dann, wenn das Aufnahmegehäuse zumindest bereichsweise eine zylindrische Außenfläche aufweist, die der Anschlusswand gegenübersteht, insbesondere zumindest bereichsweise an dieser anliegt. Bei unterschiedlichen Bauvarianten kann in diesem Fall insbesondere die Anbaupositionen des Elektronikgehäuses an dem Aufnahmegehäuse, abhängig von den geometrischen Gegebenheiten vom Konstrukteur variiert werden. Insbesondere kann das Elektronikgehäuse bezüglich der Umfangsrichtung des Aufnahmegehäuses variabel positioniert werden, was eine Verwendung bei unterschiedlichen Packages erlaubt.

Für eine sichere Befestigung des Elektronikgehäuses an dem Aufnahmegehäuse kann es vorgesehen sein, dass im Bereich der Anschlusswand wenigstens eine Ausnehmung und/oder wenigstens ein Vorsprung mit Befestigungsaufnahmen vorgesehen ist, die/der eine ebene Befestigungsfläche bildet. Das Elektronikgehäuse kann mit der ebenen Befestigungsfläche definiert an einer entsprechend gestalteten Gegenfläche des Aufnahmegehäuses spielfrei positioniert werden. Mit den Befestigungsaufnahmen, beispielsweise Schraubaufnahmen, kann das Elektronikgehäuse am Aufnahmegehäuse sicher befestigt werden.

Es ist von besonderem Vorteil, wenn vorgesehen ist, dass die Befestigungsfläche im Bereich des Massenschwerpunkts der Elektronikeinheit oder im Bereich des Flächenschwerpunkts des die Befestigungsfläche schneidenden Querschnitts des Elektronikgehäuses verläuft. Bei einer solchen Bauweise wird die Befestigungsstelle zur Ankopplung an das Aufnahmegehäuse vergleichsweise wenig beansprucht, wenn das Elektronikgehäuse Vibrationen ausgesetzt ist.

Eine erfindungsgemäße Elektronikeinheit kann insbesondere dergestalt sein, dass zumindest zwei Befestigungsflächen vorgesehen sind, wobei eine Befestigungsfläche im Endbereich der Anschlusswand dort in einem Bereich vorgesehen ist, in dem der Aufnahmeraum seine kleinste Bauraumhöhe aufweist. Hierdurch kann insbesondere eine große Beabstandung der beiden Befestigungsflächen verwirklicht werden.

Zur Unterstützung einer platzsparenden Bauweise kann es vorgesehen sein, dass auf der Leiterplatte ein Controller befestigt ist, der einen Niederspannungsanschluss aufweist oder dem ein solcher Niederspannungsanschluss zugeordnet ist, wobei der Niederspannungsanschluss einen Steckverbinder aufweist, der durch die Anschlusswand geführt und dort in einem Bereich vorgesehen ist, in dem der Aufnahmeraum seine kleinste Bauraumhöhe aufweist. Alternativ kann es auch vorgesehen sein, dass der Steckverbinder durch eine der Seitenwände im Bereich der geringsten Höhe des Elektronikgehäuses geführt wird.

Eine einfache Montage und Wartung der Elektronikeinheit kann dadurch erreicht werden, dass die Gehäuseöffnung derart dimensioniert ist, dass die mit Elektronikkomponenten der Leistungselektronik bestückte Leiterplatte durch die Gehäuseöffnung hindurch in den Aufnahmeraum einsetzbar ist.

Eine platzoptimierte Anordnung der Komponenten der Leistungselektronik ergibt sich insbesondere dann, wenn vorgesehen ist, dass in dem Bereich, in dem der Aufnahmeraum seine größte Bauhöhe aufweist, ein oder mehrere Kondensatoren angeordnet sind und/oder dass in dem Bereich in dem der Aufnahmeraum seine kleinste Bauhöhe aufweist, ein oder mehrere gedruckte Schaltungen auf der Leiterplatte und/oder in einem Mittenbereich zwischen der größten und der kleinsten Bauraumhöhe des Aufnahmeraums elektronische Schaltelemente, insbesondere MOSFETs, IGBTs oder Transistoren angeordnet sind.

Von besonderem Vorteil ist es, wenn vorgesehen ist, dass das Elektronikgehäuse Wände aufweist, die einen Kühlmittelkanal derart begrenzen, das der Kühlmittelkanal im Bereich des Aufnahmeraums verläuft. Damit kann die Verlustwärme der Leistungselektronik zumindest teilweise in ein im Kühlmittelkanal geführtes Kühlmedium abgetauscht werden.

Eine effektive Kühlung wird insbesondere dann möglich, wenn vorgesehen ist, dass zumindest ein elektrisches Bauteil, vorzugsweise der zumindest eine elektronische Schalter, an zumindest einer der den Kühlmittelkanal begrenzenden Wände anliegt, wobei vorzugsweise eine Wärmeleitpaste im Bereich zwischen der Wand und dem elektrischen Bauteil gehalten ist.

Erfindungsgemäß kann es auch vorgesehen sein, dass zumindest eines der elektrischen Bauteile der Leistungselektronik mit Kontaktanschlüssen elektrisch leitend mit der Leiterplatte verbunden und mittels einer Befestigungsklemme federvorgespannt gegen eine der Wände des Elektronikgehäuses gedrückt ist. Dies ermöglicht die sichere Festlegung des elektrischen Bauteils, wobei durch die Befestigungsklemme die Kontaktanschlüsse mechanisch entlastet werden. Vorzugsweise werden auf diese Weise die elektronischen Schalter befestigt. Besonders bevorzugt erfolgt die Befestigung gegen eine der Wände des Kühlmittelkanals. Hierdurch kann neben einer zuverlässigen Befestigung auch eine effektive Abfuhr der Verlustwärme dieser elektronischen Schalter gewährleistet werden.

Besonders bevorzugt ist es vorgesehen, dass in Richtung der Gehäuselänge mehrere Kondensatoren und/oder mehrere elektronische Schalter hintereinander aufgereiht sind und/oder dass sich der Kühlkanal in Richtung der Gehäuselänge erstreckt. Hierdurch wird die kompakte Bauweise der Elektronikeinheit unterstützt.

Eine mögliche Erfindungsvariante kann dergestalt sein, dass zumindest einer der Kondensatoren ein der Leiterplatte abgewandtes Ende aufweist, und wobei im Aufnahmeraum zwischen diesem Ende und einer Seitenwand des Elektronikgehäuses wenigstens ein EMV-Filter (Elektromagnetische Verträglichkeit-Filter) angeordnet ist, wobei vorzugsweise vorgesehen ist, dass der EMV-Filter über eine Anschlussleitung an die Leiterplatte elektrisch angeschlossen ist, und wobei besonders bevorzugt die Anschlussleitung in einem Kabelkanal zwischen einer Außenseite des Kondensators und einer quer zur Leiterplatte verlaufenden Seitenwand des Elektronikgehäuses untergebracht ist.

Erfindungsgemäß kann es auch vorgesehen sein, dass im Bereich der Anschlusswand, vorzugsweise im Bereich einer Befestigungsfläche, ein Durchbruch angeordnet ist, durch den Hochspannungsleitungen von den elektronischen Schaltern zum Anschluss des Elektromotors geführt sind. Dies ermöglicht eine direkte Leitungsführung von der Leistungselektronik zum Elektromotor. Hierdurch werden Leitungsverluste minimiert. Wenn der Durchbruch im Bereich der Befestigungsfläche angeordnet ist, so werden eventuelle Wechselspannungen, die infolge von Vibrationen auf die Stromleitungen einwirken, minimiert.

Die Erfindung wird im Folgenden anhand eines in den Zeichnungen dargestellten Ausführungsbeispiels näher erläutert. Es zeigen:
Figur 1 in Seitenansicht einen elektromotorisch unterstützen Abgasturbolader mit einer angebauten Elektronikeinheit,
Figur 2 in Seitenansicht eine weitere Ausgestaltungsvariante eines elektromotorisch unterstützten Abgasturboladers mit der in einer anderen Lage montierten Elektronikeinheit aus Fig. 1 ,
Figur 3 die Elektronikeinheit gemäß den Figuren 1 und 2 in Einzeldarstellung und perspektivischer Ansicht,
Figur 4 die Elektronikeinheit gemäß Figur 3 in Seitenansicht und im Schnitt,
Figur 5 eine Schnittdarstellung der Elektronikeinheit gemäß den Figuren 3 und 4 längs des in Figur 4 mit V-V markierten Schnittverlaufs und
Figur 6 die Elektronikeinheit gemäß den Figuren 3 bis 5 im Teilschnitt und in Ansicht von vorne.

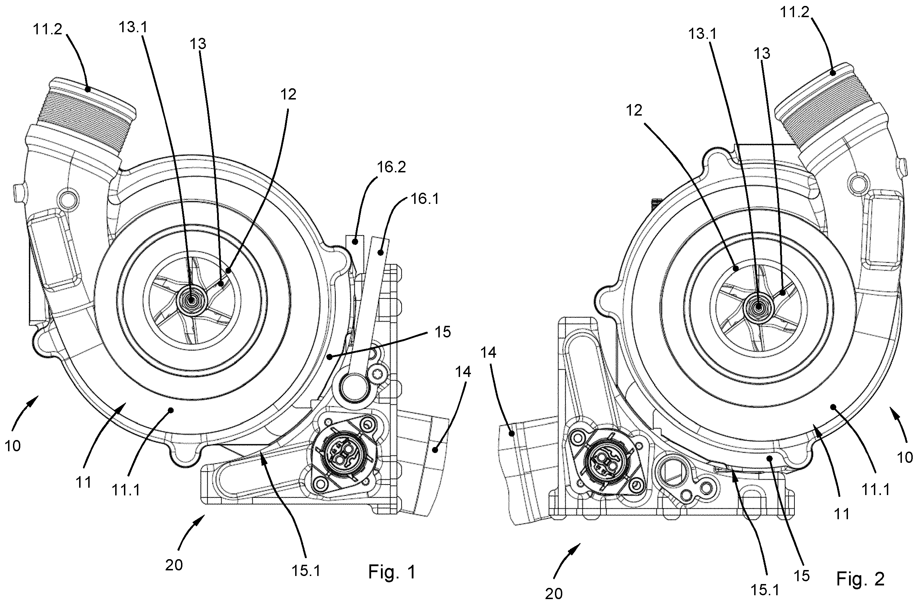

In Figur 1 ist ein elektromotorisch unterstützter Verdichter 10, insbesondere Gasverdichter gezeigt. Im vorliegenden Ausführungsbeispiel handelt es sich bei dem Verdichter 10 um einen elektromotorisch unterstützen Abgasturbolader.

Im Rahmen der Erfindung können jedoch auch beliebige andere elektromotorisch unterstützte oder angetriebene Gasverdichter berücksichtigt sein. Insbesondere kann es sich bei solchen Gasverdichtern um elektromotorisch unterstützte Turbolader oder elektromotorisch unterstützte Gasverdichter handeln, die eine motorische Einheit, insbesondere einen Verbrennungsmotor oder eine Brennstoffzelle mit einem verdichteten Gasstrom versorgen.

Der Verdichter 10 weist ein Aufnahmegehäuse 11 auf. In diesem Aufnahmegehäuse ist ein Elektromotor (nicht dargestellt) untergebracht. Der Elektromotor treibt mittelbar oder unmittelbar eine Antriebswelle 13.1 an. Auf dieser Antriebswelle 13.1 ist ein Verdichterrad 13 befestigt. Das Verdichterrad 13 ist in einem Spiralgehäuse 11.1 untergebracht, das integraler oder separater Bestandteil des Aufnahmegehäuses 11 ist. Diesem Spiralgehäuse 11.1 ist ein Gaseinlass 12 zugeordnet. Über den Gaseinlass 12 kann Frischluft angesaugt werden. Die Frischluft wird von dem Verdichterrad 13 verdichtet. Die komprimierte Luft kann über den Gasauslass 11.2 abgeleitet, beispielsweise einem Verbrennungsmotor zugeführt werden.

Wenn es sich, wie im vorliegenden Ausführungsbeispiel, um einen Abgasturbolader handelt, so ist mit der Antriebswelle 13.1 auch ein Turbinenrad gekoppelt, welches im Abgasstrom des Verbrennungsmotors betrieben und von diesem angetrieben wird. Das Turbinenrad ist in einem Turbinengehäuse untergebracht. Das Turbinengehäuse ist integraler oder separater Bestandteil des Aufnahmegehäuses 11. Mit dem im Aufnahmegehäuse 11 angeordneten Elektromotor kann die Antriebswelle 13.1 angetrieben werden (zum Beispiel Turbolader) oder es wird die durch das Turbinenrad in die Antriebswelle 13.1 eingebrachte Bewegungsenergie mittels des Elektromotors unterstützt (zum Beispiel Abgasturbolader).

Wie Figur 1 erkennen lässt, weist das Turbinengehäuse einen Turbinenauslass 14 und einen Turbineneinlass auf. Über den Turbineneinlass wird der Abgasstrom dem Turbinenrad zugeleitet. Über den Turbinenauslass 14 wird der Abgasstrom in die Auspuffanlage abgeleitet.

Figur 1 zeigt, dass das Aufnahmegehäuse 11 einen Verbindungsabschnitt 15 mit einer Außenfläche 15.1 aufweist. Die Außenfläche 15.1 ist zumindest bereichsweise konvex gewölbt. Im Rahmen der Erfindung kann sich die Außenfläche 15.1 über zumindest 45°, vorzugsweise zumindest über 60° des Außenumfangs des Aufnahmegehäuses 11 erstrecken. Die maximale Erstreckung der Außenfläche 15.1 über den Außenumfang des Aufnahmegehäuses 11 sollte kleiner oder gleich 180° gewählt werden.

Wie Figur 1 weiter zeigt, kann eine Elektronikeinheit mit einem Elektronikgehäuse 20 mit dem Aufnahmegehäuse 11 verbunden werden. In dem Elektronikgehäuse 20 ist eine Leistungselektronik und ein Controller zur Steuerung der Leistungselektronik untergebracht. Mittels der Leistungselektronik kann der Elektromotor mit Strom versorgt werden.

Das Elektronikgehäuse 20 besitzt eine Anschlusswand 21. Mit dieser Anschlusswand 21 ist das Elektronikgehäuse 20 zumindest abschnittsweise an die Außenfläche 15.1 des Verbindungsabschnitts 15 des Aufnahmegehäuses 11 angelegt. Über geeignete Befestigungsmittel kann das Elektronikgehäuse 20 dann mit dem Aufnahmegehäuse 11 verbunden werden.

Wie Figuren 1 und 2 zeigen, kann das Elektronikgehäuse 20 mit unterschiedlich gestalteten Aufnahmegehäusen 11 eines Abgasturboladers verbunden werden. Zu diesem Zweck ist es lediglich erforderlich, dass die Aufnahmegehäuse 11 im Bereich ihrer Außenfläche 15.1 eine einheitlich gestaltete Schnittfläche zur Ankopplung des Elektronikgehäuses 20 zur Verfügung stellen. Auf diese Weise kann eine bausatzartige Gestaltung erreicht werden, die zu einer Verringerung des Teileaufwands führt.

Figur 1 gibt zu erkennen, dass dem Elektronikgehäuse 20 ein Kühlkreislauf mit einer Zuführleitung 16.1 und einer Ableitung 16.2 zugeordnet sein kann. Über die Zuführleitung 16.1 wird dem Elektronikgehäuse 20 ein Kühlmittel zugeleitet. Das Kühlmittel kann durch einen Kühlmittelkanal 47 des Elektronikgehäuses 20 hindurchgeführt und über die Ableitung 16.2 wieder aus dem Elektronikgehäuse 20 abgeleitet werden. Beim Durchtritt durch den Kühlmittelkanal 47 des Elektronikgehäuses 20 nimmt das Kühlmittel die Verlustwärme der Leistungselektronik oder eines Teils der Leistungselektronik auf.

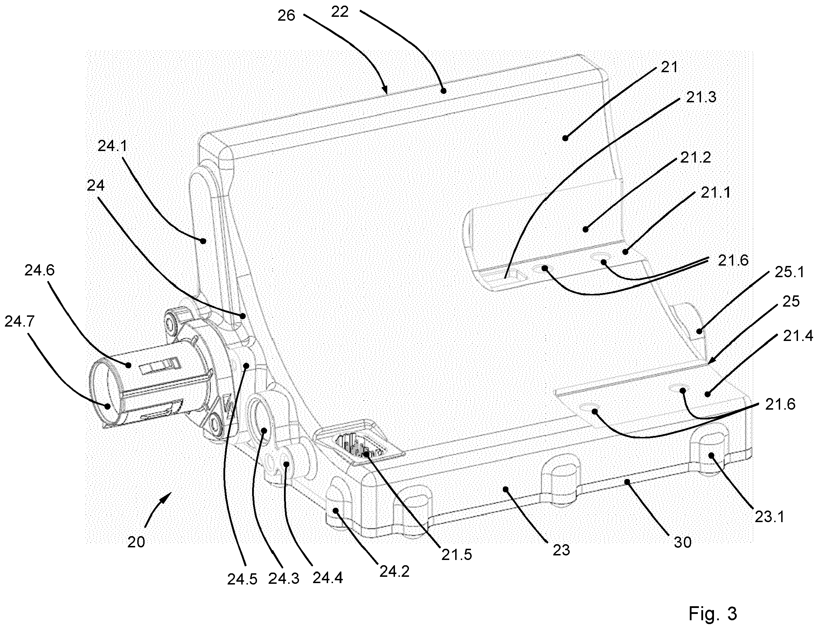

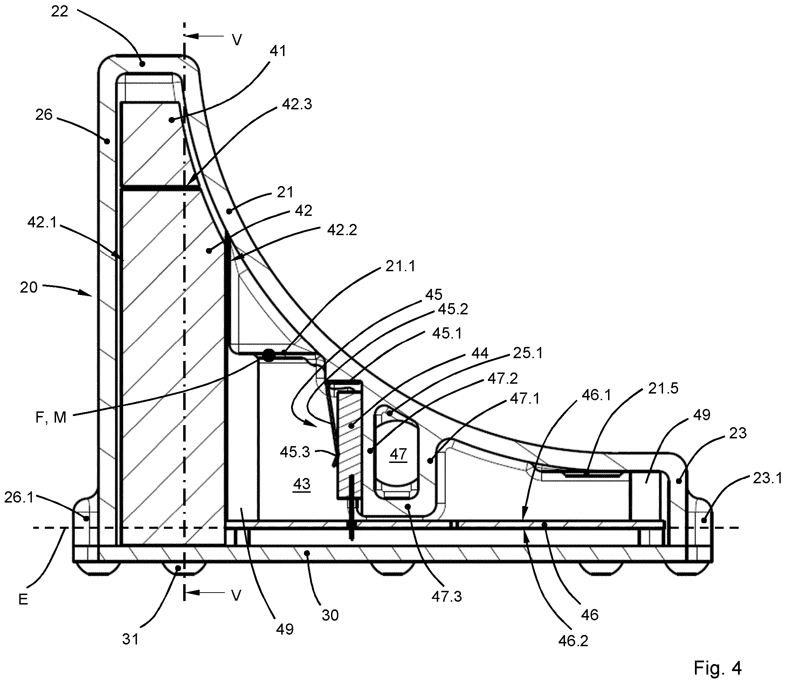

Die Figuren 3 und 4 zeigen den Aufbau des Elektronikgehäuses 20 deutlicher. Wie diese Darstellungen veranschaulichen, weist das Elektronikgehäuse 20 eine Anschlusswand 21 auf. Mit dieser Anschlusswand 21 kann das Elektronikgehäuse 20 an die Außenfläche 15.1 des Aufnahmegehäuses 11 angelegt werden. Bevorzugterweise weist die Außenfläche 15.1 dabei zumindest in Teilbereichen die gleiche Form auf, wie die Außenfläche 15.1. Im vorliegenden Ausführungsbeispiel ist die Außenfläche 15.1 konvex und die Anschlusswand 21 passend dazu konkav gestaltet.

An den längsseitigen Enden der Anschlusswand 21 besitzt das Elektronikgehäuse 20 zwei einander gegenüberliegende Seitenwände 24, 25. Diese beiden Seitenwände 24, 25 besitzen jeweils einen Durchbruch, wobei der eine Durchbruch der ersten Seitenwand 24 einen Kühlmitteleinlass 24.3 bildet. Dieser Kühlmitteleinlass 24.3 steht in Verbindung mit der Zuführleitung 16.1. Die zweite Seitenwand 25 besitzt einen Kühlmittelauslass 25.1. Der Kühlmittelauslass 25.1 steht in Verbindung mit der Ableitung 16.2. Der Kühlmitteleinlass 24.3 und der Kühlmittelauslass 25.1 sind Teil eines Kühlmittelkanals 47, der durch das Elektronikgehäuse 20 geleitet wird, wie dies später näher erläutert wird.

Wie Figur 3 veranschaulicht, kann zumindest eine der Seitenwände 24 auch mit einem Koppelelement 24.5 ausgestattet sein. Das Koppelelement 24.5 dient zur Anbindung einer Kabeldurchführung 24.6. Die Kabeldurchführung 24.6 weist eine Durchführung 24.7 auf. Durch diese Durchführung 24.7 kann ein Kabel in den Innenraum des Elektronikgehäuses 20 geführt werden. Beispielsweise lässt sich ein Gleichspannung führendes Kabel mit Batteriespannung in den Innenraum des Elektronikgehäuses führen. Besonders bevorzugt bildet die Kabeldurchführung 24.6 eine abgedichtete Kabeldurchführung. Insbesondere kann an diesem Element auch eine Zugentlastung für das Kabel vorgesehen sein.

Denkbar ist es auch, dass im Bereich einer der Seitenwände 24, 25 ein Masseanschluss 24.4 vorhanden ist. Mit diesem Masseanschluss 24.4 kann die Leistungselektronik geerdet werden.

An den querseitigen Enden schließen sich an die Anschlusswand 21 Seitenwände 23, 26 an. Zudem sind diese Seitenwände 23, 26 an ihren längsseitigen Enden in die Seitenwände 24, 25 übergeleitet, vorzugsweise mittels gerundeten Verbindungsabschnitten. Das Elektronikgehäuse 20 bildet im Bereich seiner Rückseite eine weitere Seitenwand 26. Diese Seitenwand 26 ist mittels der Seitenwand 22 beabstandet zu der Anschlusswand 21 gehalten.

Die Seitenwände 24, 25, 23 und 26 umschließen eine Gehäuseöffnung. Durch diese Gehäuseöffnung hindurch ist der Aufnahmeraum des Elektronikgehäuses 20 zugänglich. Die Gehäuseöffnung kann mit einer Abdeckung 30 verschlossen werden. Zur lösbaren Verbindung der Abdeckung 30 sind an den Seitenwänden 23, 24 und 26 Schraubansätze 23.1, 24.2 und 26.1 vorgesehen. Diese Schraubansätze 23.1, 24.2 und 26.1 können insbesondere als angeformte seitliche Verdickungen, die außenseitig über die zugeordneten Seitenwände 23, 24, 25 und 26 vorstehen, ausgebildet sein.

Wie Figur 4 zeigt, besitzt das Elektronikgehäuse 20 in Seitenansicht einen trapezförmigen Querschnitt. Dieser trapezförmige Querschnitt wird gebildet von der Anschlusswand 21 und den Seitenwänden 22, 23 und 26 sowie von der Abdeckung 30. Anstelle eines trapezförmigen Querschnitts kann auch beispielsweise ein dreieckförmiger Querschnitt vorgesehen sein. Dieser dreieckförmige Querschnitt wäre dann von der Anschlusswand 21, der Seitenwand 26 und der Abdeckung 30 begrenzt.

Figur 3 zeigt, dass das Elektronikgehäuse 20 im Bereich der Anschlusswand 21 Befestigungsflächen 21.1 und 21.4 aufweist. Diese Befestigungsflächen 21.1 und 21.4 können insbesondere als ebene Flächen ausgebildet sein. Korrespondierend zu wenigstens einer dieser Befestigungsflächen 21.1 und 21.4 kann das Aufnahmegehäuse 11 eine geometrisch angepasste Gegenfläche im Bereich der Außenfläche 15.1 aufweisen. Wie Figur 3 weiter zeigt, können die Befestigungsflächen 21.1 und 21.4 mit Schraubaufnahmen 21.6 ausgestattet sein. Von der Innenseite des Elektronikgehäuses 20 her können dann Befestigungsschrauben durch die Schraubaufnahmen 21.6 hindurchgeführt und in Gewindeaufnahmen des Aufnahmegehäuses 11 eingeschraubt werden. Auf diese Weise lässt sich das Elektronikgehäuse 20 mit dem Aufnahmegehäuse 11 verbinden.

Vorzugsweise ist die Befestigungsfläche 21.1 im Bereich des projizierten Flächenschwerpunkts F des Querschnitts des Elektronikgehäuse (zum Beispiel dreieckförmiger Querschnitt oder trapezförmiger Querschnitt) angeordnet. Besonders bevorzugt ist die Befestigungsfläche 21.1 im Bereich des Massenschwerpunkts M der Elektronikeinheit angeordnet, welche sich zusammen mit dem fertigmontierten Elektronikgehäuse und der darin angeordneten Leistungselektronik ergibt.

Die Befestigungsfläche 21.4 ist im Bereich der Seitenwand 23 angeordnet und damit im großen Abstand zu der Befestigungsfläche 21.1 angeordnet. Über diese Beabstandung ergibt sich ein großer Stützabstand und damit eine sichere Befestigung des Elektronikgehäuses 20.

Figur 3 zeigt, dass im Bereich der Anschlusswand 21, vorzugsweise im Bereich der Ausnehmung, die die Befestigungsfläche 21.1 bildet, auch ein Durchbruch 21.3 vorgesehen sein kann. Dieser Durchbruch 21.3 dient zur Durchführung der Stromversorgungskabel, die dem Elektromotor zugeleitet sind. Weiterhin kann ein Stromanschluss 21.5 in Form eines Steckkontakts im Bereich der Anschlusswand 21 gehalten sein. Dieser Stromanschluss 21.5 kann die Niederspannungsversorgung einer elektrischen Schaltung bilden, die innerhalb des Elektronikgehäuses 20 angeordnet ist. Im Bereich der Anschlusswand 21 ist der Stromanschluss 21.5 gesichert vor mechanischen Einwirkungen untergebracht.

Wie Figur 4 zeigt, kann im Innenraum des Elektronikgehäuses 20, hinter der durch die Abdeckung 30 verschlossenen Öffnung eine Installationsebene E gebildet werden. In dieser Installationsebene E ist eine Leiterplatte 46 angeordnet. Die Leiterplatte 46 kann dabei insbesondere parallel zu der Öffnung oder parallel zu der Ebene der Abdeckung 30 verlaufen. Die Leiterplatte 46 weist eine Leiterplattenoberseite 46.1 auf, die der Anschlusswand 21 zugewandt ist. Eine Leiterplattenunterseite 46.2 ist der Abdeckung 30 zugekehrt. Die Leiterplatte 46 besitzt eine Quererstreckung, welche in Figur 4 in der Bildebene von links nach rechts verläuft, also beispielsweise zwischen den beiden Seitenwänden 23 und 26. Die Längserstreckung der Leiterplatte 46 verläuft entsprechend in der Richtung der Bildtiefe gemäß Figur 4 zwischen den Seitenwänden 24 und 25. Die Leiterplatte 46 kann die oben erwähnte elektronische Schaltung aufnehmen.

Wie Figur 3 zeigt, verläuft die Anschlusswand 21 in Richtung der Quererstreckung der Leiterplatte 46 geneigt zu der Leiterplatte 46, derart, dass die senkrecht zur Leiterplatte 46 verlaufende Bauraumhöhe des Aufnahmeraums in Richtung der Quererstreckung von einer Gehäuseseite zu der gegenüberliegenden Gehäuseseite zumindest bereichsweise abnimmt.

Dementsprechend bilden sich im Bereich der Seitenwand 26 die größte Bauraumhöhe und im Bereich der Seitenwand 23 die kleinste Bauraumhöhe. Im Bereich der größten Bauraumhöhe sind mehrere Kondensatoren 42 angeordnet. Dabei sind die Kondensatoren 42 in Richtung der Gehäuselänge, welche in Richtung der Längserstreckung der Leiterplatte 46 verläuft, nebeneinander angeordnet. Die Kondensatoren 42 können so angeordnet sein, dass sie mit ihrer Außenseite 42.1 gegenüberliegend der Innenseite der Seitenwand 26 und in geringem Abstand zu dieser angeordnet sind. Die gegenüberliegende Innenseite 42.2 der Kondensatoren ist dem verbleibenden Aufnahmeraum, dementsprechend auch der Anschlusswand 21 zugeordnet. Vorzugsweise sind die Kondensatoren 42 auf der Leiterplatte 46 befestigt und dort elektrisch kontaktiert. Denkbar ist es jedoch auch, dass die Kondensatoren 42, seitlich neben der Leiterplatte 46 angeordnet sind, wie Figur 4 zeigt.

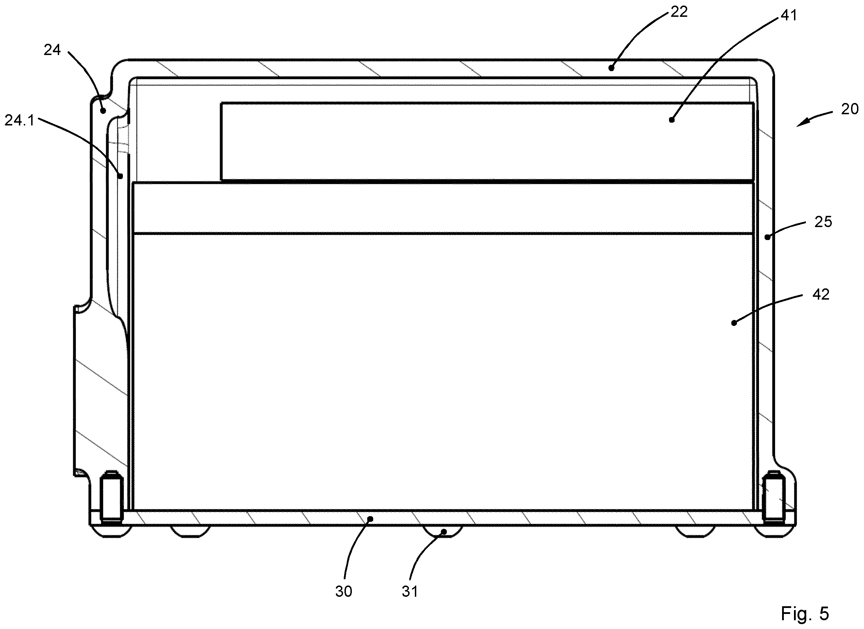

Die Gehäusegestaltung kann so getroffen werden, dass im Bereich zwischen der Oberseite 42.3 der Kondensatoren 42 und der Seitenwand 22 ein verbleibender Freiraum gebildet ist. In diesem Freiraum können EMV-Filter 41 montiert sein. Zum Anschluss der EMV-Filter 41 an die Leiterplatte 46 kann (siehe Figur 5) ein Kabelkanal 24.1 in Form einer Ausbuchtung in die Seitenwand 24 eingearbeitet sein.

Die Leiterplatte 46 kann mit einem Controller bestückt sein. Dieser Controller kann im Bereich der niedrigsten Bauraumhöhe, also in der Nähe der Seitenwand 23 angeordnet sein.

Weiterhin können auf der Leiterplatte 46 elektronische Schalter 44 befestigt und elektrisch kontaktiert sein. Bei den elektronischen Schaltern 44 kann es sich beispielsweise um MOSFET-Schalter oder um IGBT-Schalter oder andere Arten von elektronischen Schaltern 44 bzw. Transistoren handeln. Die elektronischen Schalter 44 sind in Richtung der Längserstreckung der Leiterplatte 46 (in Richtung der Bildtiefe gemäß Figur 4) nebeneinander angeordnet.

Wie Figur 4 erkennen lässt, können die elektronischen Schalter 44 zusätzlich zu ihrer Befestigung auf der Leiterplatte 46 auch mit einer weiteren mechanischen Befestigung am Elektronikgehäuse 20 befestigt werden. Zu diesem Zweck kann vorzugsweise eine Befestigungsklemme 45 verwendet werden. Die Befestigungsklemme 45 weist einen Befestigungsabschnitt 45.1 auf. Mit diesem Befestigungsabschnitt 45.1 ist die Befestigungsklammer 45 mit dem Elektronikgehäuse 20, vorzugsweise mit der Anschlusswand 21 verbunden. An den Befestigungsabschnitt 45 schließt sich ein Klemmabschnitt 45.2 an, der federelastisch ausgelenkt werden kann. Der Klemmabschnitt 45.2 schließt mit einem Auflaufabschnitt 45.3 ab.

Der Klemmabschnitt 45.2 ist federelastisch ausgelenkt und drückt auf die zugewandte Außenseite des Schalters 44. Auf diese Weise wird der Schalter 44 geklemmt zwischen dem Klemmabschnitt 45.2 auf der einen Seite und einer Wand 47.2 des Elektronikgehäuses 20 gehalten. Die Wand 47.2 ist vorzugsweise einteilig an das Elektronikgehäuse 20 angeformt, insbesondere kann die Wand 47.2 einteilig an die Anschlusswand 21 angeformt sein.

Dadurch, dass die elektronischen Schalter 44 mit dem Elektronikgehäuse 20 mechanisch gekoppelt sind, wird die elektrische Verbindung der Schalter 44 mit der Leiterplatte 46 (Platinenanschluss 44.1) mechanisch entlastet.

Besonders bevorzugt ist die Wand 47.2 Teil eines Kühlmittelkanals 47, der innerhalb des Elektronikgehäuses 20 verläuft. Der Kühlmittelkanal 47 ist von Wänden 47.1, 47.2 und 47.3 begrenzt. Wie dies oben erwähnt wurde, steht der Kühlmittelkanal 47 mit dem Kühlmitteleinlass 24.3 und mit dem Kühlmittelauslass 25.1 in Verbindung.

In dem in Figur 4 gezeigten Ausführungsbeispiel sind die elektronischen Schalter alle in einer Reihe entlang der Längsrichtung angeordnet, so dass sie alle die gleiche Wand 47.2 des Kühlmittelkanals 47 kontaktieren. Alternativ ist jedoch auch vorstellbar, dass die elektronischen Schalter 44 so angeordnet sind, dass zumindest ein elektronischer Schalter 44 die gegenüberliegende Wand 47.1 des Kühlmittelkanals 47 kontaktiert. Die elektronischen Schalter 44 sind in dieser alternativen Ausführungsform dann in paaren beidseitig des Kühlmittelkanals 47 angeordnet.

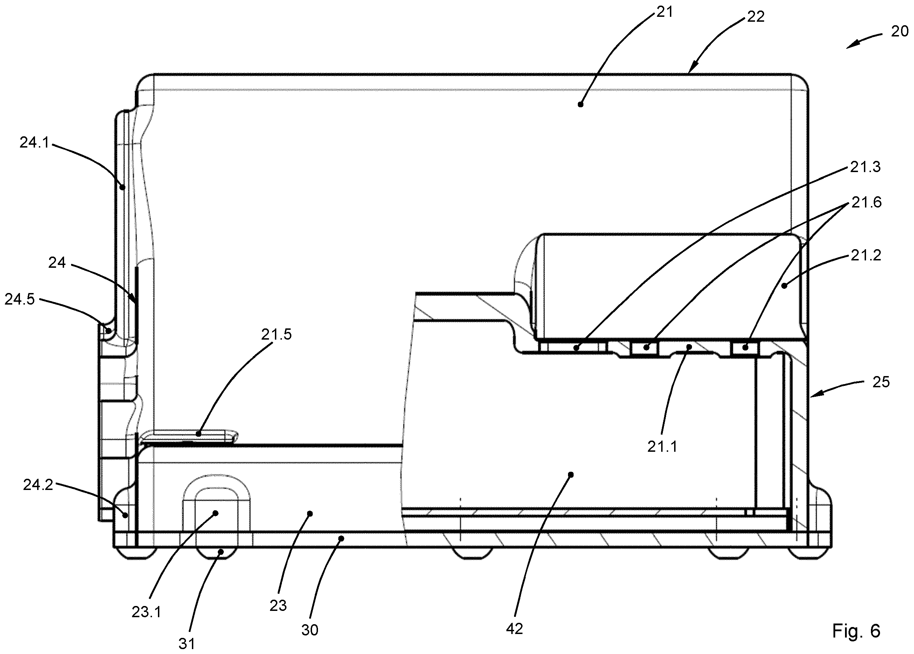

Im Bereich zwischen den Kondensatoren 20 und den elektronischen Schaltern 44 ist ein Freiraum gebildet, der als Kabelkanal 43 genutzt werden kann. In diesem Kabelkanal 43 können die von den Schaltern 44 kommenden Motorkabel geführt werden. Der Kabelkanal 43 steht in räumlicher Verbindung mit dem Durchbruch 21.3, durch den die Motorkabel geführt und in das Aufnahmegehäuse 11 geleitet werden. Dies ist in Figur 6 näher veranschaulicht.

Wie Figur 5 zeigt, erstrecken sich die Kondensatoren 42 nahezu über die gesamte Tiefe des Aufnahmeraums. Die EMV-Filter 41 hingegen nehmen eine Länge ein, die kleiner ist als die Bauraumtiefe der Kondensatoren 42. Auf diese Weise verbleibt im Aufnahmeraum im Anschluss an den Kabelkanal 24.1 ein Freiraum, der für die Verlegung der Stromversorgungskabel für die EMV-Filter 41 genutzt werden kann.

Zur Montage der erfindungsgemäßen Elektronikeinheit an dem Aufnahmegehäuse 11 wird zunächst das Elektronikgehäuse 20 mit seiner Anschlusswand 21 an die Außenfläche 15.1 des Aufnahmegehäuses 11 angesetzt. Dabei stehen die Befestigungsflächen 21.1 und 21.4 korrespondierenden Gegenflächen des Aufnahmegehäuses 11 gegenüber. Von der Innenseite des Elektronikgehäuses 20 her können Befestigungsschrauben durch die Schraubaufnahmen 21.6 hindurchgeführt und in Gewindeaufnahmen des Aufnahmegehäuses 11 eingeschraubt werden. Auf diese Weise wird das Elektronikgehäuse 20 am Aufnahmegehäuse 11 festgelegt.

Durch die Gehäuseöffnung des Elektronikgehäuses hindurch kann die fertig bestückte Leiterplatte 46 zusammen mit den Kondensatoren 42, den elektronischen Schaltern 44 und dem Mikrocontroller in das Elektronikgehäuse 20 eingesetzt werden. Die Einsetzbewegung der Leiterplatte 46 kann beispielsweise mit einteilig an der Innenseite des Elektronikgehäuses 20 angeformten Ansätzen 49 begrenzt werden. Insbesondere kann es vorgesehen sein, dass die Ansätze 49 auch mit Schraubaufnahmen für die Befestigung der Leiterplatte 46 versehen sind. Abschließend wird die Abdeckung 30 auf das Elektronikgehäuse 20 aufgesetzt und die Gehäuseöffnung somit verschlossen. Bei der Montage der Leiterplatte 46 gleiten die elektronischen Schalter 44 mit ihrem der Leiterplatte 46 abgewandten Ende auf den Auflaufabschnitt 45.3 der Befestigungsklemme 45 auf und lenken entsprechend den Klemmabschnitt 45.2 aus. Anschließend gleitet der Klemmabschnitt 45.2 an der Außenseite des elektronischen Schalters 44 vorbei, bis dieser in seine endgültige Montageposition gelangt.

Im Rahmen der Erfindung muss das Elektronikgehäuse 20 nicht als getrenntes Gehäuse ausgebildet sein. Vielmehr ist es auch denkbar, dass das Elektronikgehäuse 20 Teil des Aufnahmegehäuses 11 ist.

Die EMV-Filter 41 müssen nicht zwangsläufig im Bereich zwischen der Oberseite 42.3 der Kondensatoren 42 und der zugewandten Seitenwand 42 angeordnet sein. Vielmehr können die EMV-Filter 41 auch in einem anderen Bereich des Aufnahmeraums des Elektronikgehäuses 20 zwischen den Kondensatoren 20 und der Seitenwand 23 angeordnet sein. Insbesondere ist es denkbar, dass diese EMV-Filter 41 zwischen den Kondensatoren 20 und den elektronischen Schaltern 44 angeordnet sind, um eine geringere Bauraumhöhe des Elektronikgehäuses 20 erreichen zu können.

Im vorliegenden Ausführungsbeispiel ist der Kühlmittelkanal 47 geradlinig durch das Elektronikgehäuse 20 geführt und verläuft somit in Richtung der Längserstreckung der Anschlusswand 21. Denkbar ist es jedoch auch, dass der Kühlmittelkanal 47 in Form einer oder mehrerer Schleifen durch das Elektronikgehäuse 20 geführt ist. Weiterhin muss der Kühlmittelkanal 47 nicht zwingend einteilig in das Elektronikgehäuse 20 eingebracht sein. Vielmehr ist es denkbar, dass ein separat zu montierender Kühlkanal Verwendung findet. Insbesondere kann es auch vorgesehen sein, dass dem Kühlmittelkanal 47 zum verbesserten Wärmetransport Kühllamellen zugeordnet sind, die im Bereich des Aufnahmeraums und/oder in dem von dem Kühlmittelkanal 47 gebildeten Leitungsbereich angeordnet sind.

Die Erfindung ist nicht auf das beschriebene Ausführungsbeispiel beschränkt. Im Rahmen der Erfindung kann es vielmehr auch vorgesehen sein, dass die Elektronikeinheit zur Regelung des Elektromotors zur Regelung eines Elektromotors zum Antrieb einer Pumpe, insbesondere einer Wasserstoffrezirkulationspumpe verwendet wird.

Ebenso kann im Rahmen der Erfindung auch vorgesehen sein, dass die Elektronikeinheit zur Regelung eines elektrischen Generators, der von einer Turbine, insbesondere einer Abgasturbine angetrieben wird, verwendet wird.

## Patentansprüche

1. Elektronikeinheit zur Regelung und zum Betreiben eines Elektromotors, insbesondere zur Regelung eines Elektromotors zum Antrieb eines Verdichters, insbesondere Gasverdichters, mit einem Elektronikgehäuse (20), in dessen Aufnahmeraum eine Leistungselektronik zur Regelung des Elektromotors aufgenommen ist, wobei das Elektronikgehäuse (20) eine Anschlusswand (21) aufweist, mit der das Elektronikgehäuse (20) an eine Außenfläche (15.1) eines Aufnahmegehäuses, in dem ein Elektromotor untergebracht ist, ankoppelbar ist, **dadurch gekennzeichnet,**
**dass** das Elektronikgehäuse (20) gegenüberliegend der Anschlusswand (21) eine Gehäuseöffnung aufweist, die mit einer Abdeckung (30) verschließbar ist und durch die hindurch der Aufnahmeraum zugänglich ist, dass eine Leiterplatte (46) zur Aufnahme zumindest eines Teils der Leistungselektronik im Bereich hinter der Gehäuseöffnung im Aufnahmeraum angeordnet ist und die eine Längs- und eine Quererstreckung aufweist, wobei die Längserstreckung in Richtung der Gehäuselänge und die Quererstreckung in Richtung der Gehäusebreite verläuft, und dass die Anschlusswand (21) in Richtung der Quererstreckung der Leiterplatte (46) geneigt zu der Leiterplatte (46) verläuft, derart, dass die senkrecht zur Leiterplatte (46) verlaufende Bauraumhöhe des Aufnahmeraums in Richtung der Quererstreckung von einer Gehäuseseite zu der gegenüberliegenden Gehäuseseite zumindest bereichsweise abnimmt.

2. Elektronikeinheit nach Anspruch 1, **dadurch gekennzeichnet, dass** ein in Richtung der Quererstreckung der Leiterplatte (46) und in Richtung der Baurumhöhe verlaufender Querschnitt des Elektronikgehäuses (20) näherungsweise einen dreieckförmigen oder fünfeckförmigen, insbesondere trapezförmigen Querschnitt aufweist.

3. Elektronikeinheit nach Anspruch 1 oder 2, **dadurch gekennzeichnet, dass** die Anschlusswand (21) zumindest bereichsweise eine konkave Form aufweist.

4. Elektronikeinheit nach einem der Ansprüche 1 bis 3, **dadurch gekennzeichnet, dass** im Bereich der Anschlusswand (21) wenigstens eine Ausnehmung und/oder wenigstens ein Vorsprung vorgesehen ist die/der eine ebene Befestigungsfläche (21.1, 21.4) mit Befestigungsaufnahmen (21.6) bildet.

5. Elektronikeinheit nach einem der Ansprüche 1 bis 4, **dadurch gekennzeichnet, dass** die Befestigungsfläche (21.1) im Bereich des Massenschwerpunkts (M) der Elektronikeinheit oder im Bereich des Flächenschwerpunkts (F) des die Befestigungsfläche (21.1) schneidenden Querschnitts des Elektronikgehäuses (20) verläuft.

6. Elektronikeinheit nach einem der Ansprüche 1 bis 5, **dadurch gekennzeichnet, dass** zumindest zwei Befestigungsflächen (21.1, 21.6) vorgesehen sind, wobei eine Befestigungsfläche (21.6) im Endbereich der Anschlusswand (21) dort in einem Bereich vorgesehen ist, in dem der Aufnahmeraum seine kleinste Bauraumhöhe aufweist.

7. Elektronikeinheit nach einem der Ansprüche 1 bis 5, **dadurch gekennzeichnet, dass** auf der Leiterplatte (46) ein Controller befestigt ist, der einen Niederspannungsanschluss (21.5) aufweist oder dem ein solcher Niederspannungsanschluss (21.5) zugeordnet ist, wobei der Niederspannungsanschluss (21.5) einen Steckverbinder aufweist der durch die Anschlusswand (21) geführt und dort in einem Bereich vorgesehen ist, in dem der Aufnahmeraum seine kleinste Bauraumhöhe aufweist.

8. Elektronikeinheit nach einem der Ansprüche 1 bis 7, **dadurch gekennzeichnet, dass** die Gehäuseöffnung derart dimensioniert ist, dass die mit Elektronikkomponenten der Leistungselektronik bestückte Leiterplatte (46) durch die Gehäuseöffnung hindurch in den Aufnahmeraum einsetzbar ist.

9. Elektronikeinheit nach einem der Ansprüche 1 bis 8, **dadurch gekennzeichnet, dass** in dem Bereich in dem der Aufnahmeraum seine größte Bauhöhe aufweist ein oder mehrere Kondensatoren angeordnet sind und/oder dass in dem Bereich in dem der Aufnahmeraum seine kleinste Bauhöhe aufweist ein oder mehrere gedruckte Schaltungen auf der Leiterplatte (46) und/oder in einem Mittenbereich zwischen der größten und der kleinsten Bauraumhöhe des Aufnahmeraums elektronische Schaltelemente, insbesondere MOSFETs, IGBTs oder Transistoren angeordnet sind.

10. Elektronikeinheit nach einem der Ansprüche 1 bis 9, **dadurch gekennzeichnet, dass** das Elektronikgehäuse (20) Wände (47.1, 47.2, 47.3) aufweist, die einen Kühlmittelkanal (47) derart begrenzen, das der Kühlmittelkanal (47) im Bereich des Aufnahmeraums, insbesondere innerhalb des Aufnahmeraums verläuft.

11. Elektronikeinheit nach Anspruch 10, **dadurch gekennzeichnet, dass** zumindest ein elektrisches Bauteil, vorzugsweise der zumindest eine elektronische Schalter (44), an zumindest einer den Kühlmittelkanal (47) begrenzenden Wände (47.1, 47.2, 47.3) anliegt, wobei vorzugsweise eine Wärmeleitpaste im Bereich zwischen der Wand (47.1, 47.2, 47.3) und dem elektrischen Bauteil gehalten ist.

12. Elektronikeinheit nach einem der Ansprüche 1 bis 11, **dadurch gekennzeichnet, dass** zumindest eines der elektrischen Bauteile der Leistungselektronik mit Kontaktanschlüssen elektrisch leitend mit der Leiterplatte (46) verbunden und mittels einer Befestigungsklemme (45) federvorgespannt gegen eine der Wände (47.1, 47.2, 47.3) des Elektronikgehäuses (20) gedrückt ist.

13. Elektronikeinheit nach einem der Ansprüche 1 bis 12, **dadurch gekennzeichnet, dass** in Richtung der Gehäuselänge mehrere Kondensatoren (42) und/oder mehrere elektronische Schalter (44) hintereinander aufgereiht sind und/oder dass sich der Kühlkanal (47) in Richtung der Gehäuselänge erstreckt.

14. Elektronikeinheit nach einem der Ansprüche 1 bis 13, **dadurch gekennzeichnet, dass** zumindest einer der Kondensatoren (42) ein der Leiterplatte (46) abgewandtes Ende aufweist, und wobei im Aufnahmeraum zwischen diesem Ende und einer Seitenwand (22) des Elektronikgehäuses (20) wenigstens ein EMV-Filter (41) (Elektromagnetische Verträglichkeit-Filter) angeordnet ist, wobei vorzugsweise vorgesehen ist, dass der EMV-Filter (41) über eine Anschlussleitung an die Leiterplatte (46) elektrisch angeschlossen ist, und wobei besonders bevorzugt die Anschlussleitung in einem Kabelkanal zwischen einer Außenseite (42.1) des Kondensators (42) und einer quer zur Leiterplatte (46) verlaufenden Seitenwand (26) des Elektronikgehäuses (20) untergebracht ist.

15. Elektronikeinheit nach einem der Ansprüche 1 bis 14, **dadurch gekennzeichnet, dass** im Bereich der Anschlusswand (21), vorzugsweise im Bereich einer Befestigungsfläche (21.1), ein Durchbruch (21.3) angeordnet ist durch den Hochspannungsleitungen von den elektronischen Schaltern (44) zum Anschluss des Elektromotors geführt sind.

16. Verdichter (10), insbesondere Gasverdichter mit einer Elektronikeinheit gemäß einem der Ansprüche 1 bis 15.
